Europäisches Patentamt

European Patent Office

Office européen des brevets

(19)

(11) **EP 1 548 452 A1**

(12) **EUROPÄISCHE PATENTANMELDUNG**

(43) Veröffentlichungstag:
**29.06.2005 Patentblatt 2005/26**

(51) Int Cl.7: **G01R 31/36**

(21) Anmeldenummer: **03029862.4**

(22) Anmeldetag: **26.12.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(71) Anmelder: **Jost, Günter**
**53844 Troisdorf (DE)**

(72) Erfinder: **Jost, Günter**
**53844 Troisdorf (DE)**

(54) **Verfahren und Vorrichtung zur Ermittlung des Innenwiderstandes eines Batterieblockes**

(57)    Bei den in der Batterieprüftechnik eingeführten Verfahren ist es üblich einen gepulsten Belastungsstrom zur Bestimmung des Innenwiderstandes eines Batterieblockes zu verwenden. Bei defekten Batterieblöcken können schon gepulste Ströme von wenigen Ampere Stromstärke eine Explosion verursachen. Gegenstand dieser Erfindung ist es, dieses Risiko einer möglichen Explosion zu verhindern und somit eine sichere Bestimmung des Innenwiderstandes eines Batterieblockes durchzuführen. Das beschriebene Verfahren verwendet Stromverläufe, in denen Änderungen des Belastungsstromes nur linear durchgeführt werden. Während ein Batterieblock mit einem Strom belastet wird, wird permanent die Spannungsantwort des Batterieblockes mit einer berechneten Vergleichsspannung, basierend auf dem verwendeten Stromverlauf und einem maximal zu erwartenden Innenwiderstand, verglichen. Unterschreitet die Spannungsantwort des Batterieblockes die Vergleichsspannung, so wird der eingeprägte Strom unverzüglich ausgeschaltet.

Der Innenwiderstand eines Batterieblockes wird durch Integration während einer linearen Änderung des Stromes berechnet.

Fig. 1

EP 1 548 452 A1

**Beschreibung**

Die Erfindung betrifft ein Verfahren zur Ermittlung des Innenwiderstandes eines Batterieblockes und eine Vorrichtung zur Durchführung eines derartigen Verfahrens. Das System ist insbesondere für stationäre Bleibatterien, die aus mindestens einem Batterieblock, oder aus mehreren in Reihe geschalteten Batterieblökken bestehen, geeignet.

Um die Verfügbarkeit einer Batterieanlage sicherstellen zu können, muss eine zuverlässige Aussage über den Gesundheitszustand der Batterie getroffen werden. Ein wichtiger Parameter zur Beurteilung des Gesundheitszustandes ist der Innenwiderstand eines jeden Batterieblockes einer Batterieanlage. Die Bestimmung des Innenwiderstandes eines jeden Batterieblokkes sollte einfach und sicher durchgeführt werden können.

Es existieren angewandte Verfahren zur Widerstandsmessung an Batterien, die sich dadurch auszeichnen, dass ein Batterieblock mit einem gepulsten Strom belastet wird. Diese Verfahren nutzen den Betrag des Spannungsabfalls der Blockspannung in Verbindung mit dem Betrag des belastenden Stromes um den Innenwiderstand ermitteln zu können. Durch die Stromentnahme sinkt die Blockspannung um den Betrag $\Delta U$. Der Innenwiderstand Ri berechnet sich nach Ri = $\Delta U$/I. Eine weitere Methode besteht darin einen Batterieblock kurzzeitig für eine bestimmte Zeit mit einem Strom I zu belasten. Durch das Ausschalten des Stromes I steigt die Blockspannung sofort um einen Betrag $\Delta U$ an. Der Innenwiderstand Ri berechnet sich ebenfalls aus Ri = $\Delta U$/I. Ein weiteres Verfahren ist unter EP1068540 beschrieben.

Allen Verfahren gemeinsam ist am Beginn oder während einer Messung des Innenwiderstandes eines Batterieblockes der sprunghafte Anstieg oder Abfall des, für die Messung eingeprägten Stromes. Die sprunghaften Anstiege werden bei diesen Verfahren hauptsächlich durch das Schalten einer ohmschen Last, parallel zum Batterieblock, verursacht. Ebenfalls allen Verfahren gemeinsam ist die Tatsache, dass nur vor, oder nach der sprunghaften Änderung des Stromes die Spannungsantwort der Batterie gemessen wird. Eine unüberwachte Stromentnahme, bzw. die sprunghafte Erhöhung des Belastungsstromes kann bei defekten Batterieblöcken zu gefährlichen Temperaturerhöhungen und zur Funkenbildung innerhalb geschädigter Bereiche des Batterieblockes führen. Diese Funkenbildung kann ausreichen um einen Batterieblock zur Explosion zu bringen, vorzugsweise verschlossene Bleibatterien.

Aufgabe der Erfindung ist es, ein Verfahren anzugeben, welches den Innenwiderstand eines Batterieblockes genau erfasst und eine ungefährliche und sichere Messwertaufnahme gewährleistet.

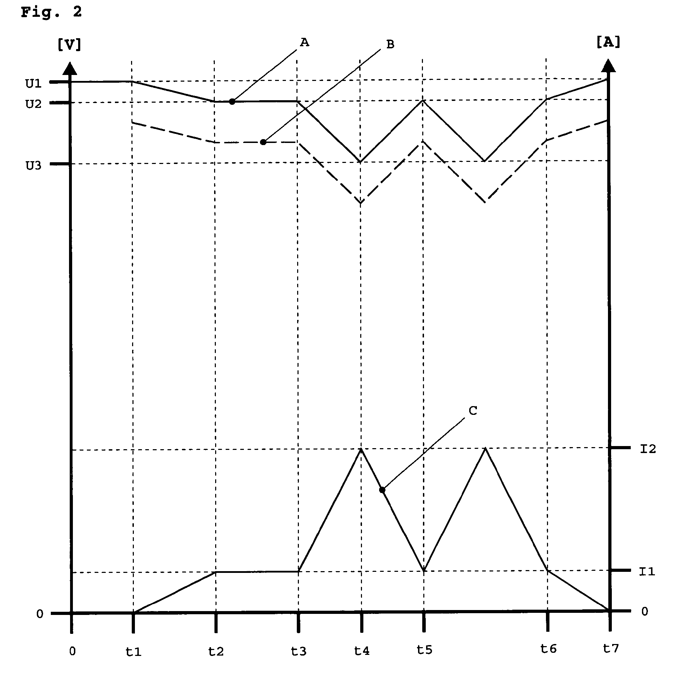

Das erfindungsgemäße Verfahren zur Bestimmung des Innenwiderstandes eines Batterieblockes ist dadurch gekennzeichnet, dass ein linearer stetig steigender Stromverlauf für Stromanstieg und ein linear stetig fallender Stromverlauf zur Stromabsenkung dem Batterieblock eingeprägt wird und das die resultierende Spannungsantwort des Batterieblockes gemessen und dass daraus der Innenwiderstand eines Batterieblockes bestimmt wird. Ausgangspunkt der Erfindung ist die Erkenntnis, dass die Spannungsantwort eines Batterieblockes, die durch eine schnelle Änderung des belastenden Stromes verursacht wird, hauptsächlich durch den Innenwiderstand des Batterieblockes bestimmt wird. Um nun den Innenwiderstand eines Batterieblockes bestimmen zu können wird folgendes Verfahren angewandt: Der Batterieblock wird mit einem vorgegebenen Stromverlauf (Fig. 2, Kurve C) belastet. Der Stromverlauf ist frei definierbar und soll jeweils für die Bereiche von Stromanstieg und Stromabfall vorzugsweise eine gleichmäßige Rampenfunktion besitzen. Der vorgegebene Stromverlauf verursacht eine Spannungsantwort (Fig. 2, Kurve A) des Batterieblockes. Die verwendete Technologie, Alter und Kapazität des zu prüfenden Batterieblockes bestimmen einen maximal zu erwartenden Innenwiderstand Rmax. Ein defekter Batterieblock kann unter Belastung eine signifikante, nicht lineare Steigerung des Innenwiderstandes über Rmax erfahren. Aus diesem Grund wird während einer Stromentnahme aus dem Batterieblock kontinuierlich die Spannungsantwort des Batterieblockes (Fig. 2, Kurve A) mit einer Vergleichsspannung (Fig. 2, Kurve B) verglichen. Ist die Spannungsantwort des Batterieblockes kleiner als die zugehörige Vergleichsspannung, so wird zur Sicherheit unverzüglich der Strom ausgeschaltet.

Die Vergleichsspannung berechnet sich nach Uv(t) = U1 - (Rmax $\times$ I(t) $\times$ k1) für t1 $\leq$ t < t3 und nach Uv(t) = U2 - (Rmax x I(t) x k2) für t $\geq$ t3. Die Faktoren k1, k2 sind Gewichtungsfaktoren und sind von dem Batterietyp des zu testenden Batterieblockes abhängig.

Im Zeitraum von t1 bis t2 wird der Strom bis auf einen Wert von I1 erhöht. Dieser Strom wird bis zum Zeitpunkt t3 konstant gehalten. Diese anfängliche Stromeinprägung wird zur Stabilisierung der Blockspannung unter Last vorgenommen, ist aber zur Bestimmung des Innenwiderstandes eines Batterieblockes nicht zwingend notwendig durchzuführen. Die Messwerte für die erforderlichen Strommessungen und Spannungsmessungen werden gleichzeitig erfasst. Ab dem Zeitpunkt t3 beginnt der Integrationsvorgang zur Ermittlung des Innenwiderstandes eines Batterieblokkes. Zum Zeitpunkt t3 wird der Spannungswert der Blockspannung U2 und der Stromwert 11 gespeichert. Der zu entnehmende Strom wird in der Zeitspanne von t3 bis t4 auf einen Wert von 12 erhöht. Dieser Stromanstieg ist frei definierbar und liegt hauptsächlich in einem Bereich von 0,01 bis 0,1 Sekunden. Unter der ansteigenden Strombelastung sinkt die Blockspannung A. Dieser Spannungsabfall wird durch den Innenwiderstand des Batterieblockes verursacht. Ab dem Zeitpunkt t3 werden der Stromverlauf (gebildet aus I(t) abzüglich des Stromwertes I1) und der Spannungsverlauf (gebildet aus U(t) abzüglich des Spannungswertes U2) zur Bestimmung des Innenwiderstandes eines Batterieblockes kontinuierlich integriert. Die Integrationszeit ist frei definierbar. Es sei tA = t3, der Startzeitpunkt der Integration. Es sei tE der frei bestimmbare Endpunkt der Integrationszeit. Anhand Fig. 2 soll tE vorzugsweise der Wert t4, t5 oder t6 zugewiesen werden. Der Innenwiderstand Ri eines Batterieblockes berechnet sich nach folgender Formel:

$$
Ri = \frac{\int\limits_{tA}^{tE} [\,|\,U(t)-U2\,|\,]\, dt}{\int\limits_{tA}^{tE} [\,|\,I(t)-I1\,|\,]\, dt}
$$

Das Spannung/Zeit-Integral integriert nur die Änderung der Blockspannungskurve ab dem Startzeitpunkt (tA) der Integrationsphase. Das Strom/Zeit-Integral integriert nur die Änderung des Stromes ab dem Startzeitpunkt der Integrationsphase. Die Integration wird nur während einer kontinuierlichen Änderung des Stromverlaufes durchgeführt. Der Strom wird nach Erreichen von tE ausgeschaltet (Fig. 2 im Zeitbereich t6 bis t7).

Der Vorteil dieses Verfahrens zur Bestimmung des Innenwiderstandes eines Batterieblockes besteht darin, dass selbst bei Verwendung hoher Ströme eine ungefährliche und sichere Messwertaufnahme durchgeführt werden kann. Belastungsströme werden nicht sprunghaft geändert, sondern verändern sich linear stetig steigend oder linear stetig fallend, so dass die Spannungsantwort des Batterieblockes derart überwacht werden kann, dass vor Erreichen gefährlicher Innenwiderstandserhöhungen der Messvorgang sicher abgebrochen werden kann.

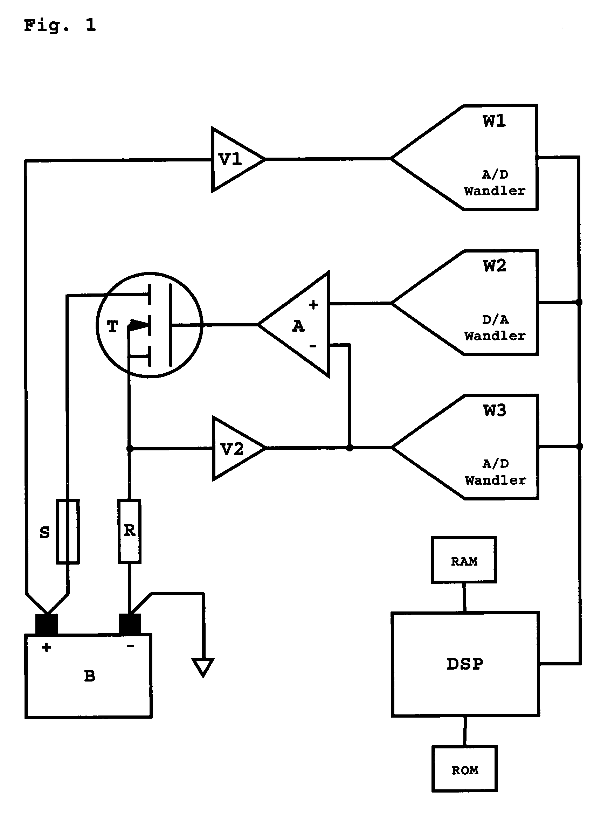

In Fig. 1 ist ein Beispiel für den Aufbau eines erfindungsgemäßen Systems zur Bestimmung des Innenwiderstandes eines Batterieblockes dargestellt.

Ein Batterieblock B wird in Vier-Leiter-Technik an das Messsystem angeschlossen. Der Strompfad wird über Plus-Pol, Sicherung S, Leistungstransistor T, Messwiderstand R (Shunt) und Minus-Pol geführt. Der Spannungspfad wird durch die Verbindung von Plus-Pol zum Verstärker V1 und durch die Verbindung des Minus-Pols des Batterieblockes mit Systemmasse des Messsystems gebildet. Ein definierter Strom wird über den D/A-Wandler W2 gesteuert. Der Operationsverstärker A vergleicht ständig das Ausgangssignal des D/A-Wandlers mit dem über V2 angepassten Stromsignal und steuert den Leistungstransistor T. Der A/D-Wandler W1 erfasst die über V1 angepasste Blockspannung, der A/D-Wandler W3 erfasst über V2 den Stromwert. Ein leistungsstarker Signalprozessor DSP steuert gleichzeitig den Stromverlauf und die Messwertaufnahme. Online berechnete, oder im ROM des DSP hinterlegte Stromwerte werden an den D/A-Wandler W2 übermittelt. Hierdurch wird ein vordefinierter Verlauf des Belastungsstromes dem Batterieblock eingeprägt. Die A/D-Wandler W1 und W3 arbeiten synchron mit Taktraten ≥ 100KHz. Der DSP vergleicht kontinuierlich die erfasste Blockspannung mit der intern gebildeten Vergleichsspannung. Unterschreitet die gemessene Blockspannung die Vergleichsspannung, so wird unverzüglich der Strom ausgeschaltet. Der erfasste Spannungsverlauf und Stromverlauf wird im RAM abgelegt und anschließend digital gefiltert. Der DSP berechnet nach genannten Formeln den Innenwiderstand des Batterieblockes.

## Patentansprüche

1. Verfahren zur Bestimmung des Innenwiderstandes eines Batterieblockes, **dadurch gekennzeichnet, dass** ein Batterieblock mit einem vorgegebenen Stromverlauf belastet wird und das die resultierende Spannungsantwort des Batterieblockes gemessen und dass daraus der Innenwiderstand eines Batterieblockes bestimmt wird.

2. Verfahren nach Anspruch 1, **dadurch gekennzeichnet, dass** der verwendete Stromverlauf nur lineare Verläufe während einer Änderung des Stromes besitzt.

3. Verfahren nach einem der vorhergehenden Ansprüche, **dadurch gekennzeichnet, dass** der vorgegebene Stromverlauf und die resultierende Spannungsantwort des Batterieblockes gleichzeitig erfasst werden.

4. Verfahren nach einem der vorhergehenden Ansprüche, **dadurch gekennzeichnet, dass** nur während einer linearen Änderung des Stromes die Integration zur Bestimmung des Innenwiderstandes eines Batterieblockes durchgeführt wird.

5. Verfahren nach einem der vorhergehenden Ansprüche, **dadurch gekennzeichnet, dass** nur der Verlauf der Änderung von Strom und Spannung ab dem Startzeitpunkt der Integrationsphase integriert werden.

6. Verfahren nach einem der vorhergehenden Ansprüche, **dadurch gekennzeichnet, dass** bei Stromentnahme aus dem Batterieblock der aktuelle Spannungswert des Batterieblockes permanent mit dem Spannungswert einer berechneten Vergleichsspannung, basierend auf dem verwendeten Stromverlauf und einem maximal zu erwartenden Innenwiderstand, verglichen wird.

**7.** Verfahren nach einem der vorhergehenden Ansprüche, **dadurch gekennzeichnet, dass** der Strom sofort abgeschaltet wird, sobald der tatsächliche Spannungswert der Blockspannung kleiner als der vorherberechnete Spannungswert der sicheren Vergleichsspannung wird.

**8.** Verfahren nach einem der vorhergehenden Ansprüche, **dadurch gekennzeichnet, dass** die Temperatur des Batterieblockes erfasst werden kann um die Strommessung und Spannungsmessung mit der Temperatur korrelieren zu können.

**9.** Verfahren nach einem der vorhergehenden Ansprüche, **dadurch gekennzeichnet, dass** ein digitaler Signalprozessor die sichere Steuerung des Stromverlaufes vornimmt und die Integration des Spannungsverlaufes und des Stromverlaufes zur Bestimmung des Innenwiderstandes durchführt.

Fig. 1

EP 1 548 452 A1

**Fig. 2**

# EP 1 548 452 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | PATENT ABSTRACTS OF JAPAN vol. 2000, no. 06, 22. September 2000 (2000-09-22) & JP 2000 088934 A (FUJITSU DENSO LTD), 31. März 2000 (2000-03-31) | 1-7,9 | G01R31/36 |
| Y | * Absatz [0008] - Absatz [0021]; Abbildungen 1-4 * * Zusammenfassung * --- | 8 | |
| X | US 2002/008523 A1 (KLANG JAMES K) 24. Januar 2002 (2002-01-24) | 1 | |
| Y | * Absatz [0071] - Absatz [0074]; Abbildung 8 * | 8 | |
| A | --- | 2,5-7,9 | |
| A | US 4 968 942 A (PALANISAMY THIRUMALAI G) 6. November 1990 (1990-11-06) * Spalte 2, Zeile 65 - Spalte 4, Zeile 36; Abbildungen 1,7A-7D * * Spalte 10, Zeile 7 - Spalte 12, Zeile 24 * --- | 1-3,9 | |
| D,A | EP 1 068 540 B (BTECH INC) 17. Januar 2001 (2001-01-17) * Absatz [0013] - Absatz [0014] * --- | 1-3,9 | **RECHERCHIERTE SACHGEBIETE** (Int.Cl.7) G01R |
| A | US 6 466 026 B1 (CHAMPLIN KEITH S) 15. Oktober 2002 (2002-10-15) * Spalte 2, Zeile 1 - Zeile 24 * * Spalte 4, Zeile 26 - Zeile 33 * --- | 1-3,9 | |
| A | US 5 721 688 A (BRAMWELL DENTON M) 24. Februar 1998 (1998-02-24) * Spalte 2, Zeile 23 - Spalte 5, Zeile 33; Abbildungen 1,3-6 * --- -/-- | 1-3,9 | |

Der vorliegende Recherchenbericht wurde für alle Patentansprüche erstellt

| Recherchenort | Abschlußdatum der Recherche | Prüfer |
|---|---|---|
| DEN HAAG | 3. Juni 2004 | Koll, H |

EPO FORM 1503 03.82 (P04C03)

**Europäisches Patentamt**

## EUROPÄISCHER RECHERCHENBERICHT

Nummer der Anmeldung

EP 03 02 9862

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 4 204 162 A (FROIDEVAUX JACQUES H) 20. Mai 1980 (1980-05-20) * Zusammenfassung; Abbildung 5 * ----- | 1-3,9 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| DEN HAAG | 3. Juni 2004 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 03 02 9862

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-06-2004

| Im Recherchenbericht angeführtes Patentdokument | | | Datum der Veröffentlichung | Mitglied(er) der Patentfamilie | | | Datum der Veröffentlichung |
|---|---|---|---|---|---|---|---|
| JP | 2000088934 | A | 31-03-2000 | JP | 3390906 | B2 | 31-03-2003 |
| US | 2002008523 | A1 | 24-01-2002 | US | 6259254 | B1 | 10-07-2001 |
| | | | | AU | 5320599 | A | 21-02-2000 |
| | | | | EP | 1032955 | A1 | 06-09-2000 |
| | | | | WO | 0007256 | A1 | 10-02-2000 |
| US | 4968942 | A | 06-11-1990 | US | 4937528 | A | 26-06-1990 |
| | | | | EP | 0460117 | A1 | 11-12-1991 |
| | | | | JP | 4505053 | T | 03-09-1992 |
| | | | | JP | 3213740 | B2 | 02-10-2001 |
| | | | | WO | 9010242 | A2 | 07-09-1990 |
| | | | | DE | 68924169 | D1 | 12-10-1995 |
| | | | | DE | 68924169 | T2 | 21-03-1996 |
| | | | | EP | 0438477 | A1 | 31-07-1991 |
| | | | | JP | 2966870 | B2 | 25-10-1999 |
| | | | | JP | 4502963 | T | 28-05-1992 |
| | | | | WO | 9004188 | A1 | 19-04-1990 |
| | | | | US | 5281919 | A | 25-01-1994 |
| EP | 1068540 | B | 17-01-2001 | US | 6167349 | A | 26-12-2000 |
| | | | | CA | 2325378 | A1 | 14-10-1999 |
| | | | | DE | 69900638 | D1 | 31-01-2002 |
| | | | | DE | 69900638 | T2 | 22-08-2002 |
| | | | | EP | 1068540 | A1 | 17-01-2001 |
| | | | | WO | 9951993 | A1 | 14-10-1999 |
| US | 6466026 | B1 | 15-10-2002 | US | 2003071627 | A1 | 17-04-2003 |
| US | 5721688 | A | 24-02-1998 | US | 6097193 | A | 01-08-2000 |
| US | 4204162 | A | 20-05-1980 | CH | 607344 | A5 | 15-12-1978 |
| | | | | DE | 2803014 | A1 | 27-07-1978 |
| | | | | GB | 1576575 | A | 08-10-1980 |

EPO FORM P0461

Für nähere Einzelheiten zu diesem Anhang : siehe Amtsblatt des Europäischen Patentamts, Nr.12/82